# EUROPEAN PATENT APPLICATION

(11) **EP 3 761 344 A1**
(43) Date of publication of application: **06.01.2021**
(21) Application number: 19315058.8
(22) Date of filing: 05.07.2019
(51) Int. Cl.: H01L 21/268, H01L 21/324

(54) **SYSTEM AND METHOD FOR SPATIALLY CONTROLLING AN AMOUNT OF ENERGY DELIVERED TO A PROCESSED SURFACE OF A SUBSTRATE**

(71) Applicant: Laser Systems & Solutions of Europe, 92230 Gennevilliers (FR)
(72) Inventor: Mazzamuto, Fulvio, 92230 Gennevilliers (FR); Pinsard, Bastien, 92230 Gennevilliers (FR)
(74) Representative: Jacobacci Coralis Harle

(57) **Abstract**

System (21) for spatially controlling an amount of energy delivered to a processed surface (5) of a processed substrate (1) comprising a first area (11) and a second area (13), said first area having a first combination of optical properties and thermal properties, and said second area having a second combination of optical properties and thermal properties, said first combination and second combination being different, said system comprising a light source (23) configured to emit a pulsed light beam (27) towards the processed surface (5), wherein the pulsed light beam delivers a first amount of energy (E1) onto said first area of the processed surface so that said first area reaches a first target temperature (Tt1), and a second amount of energy (E2) to said second area of the processed surface so that said second area reaches a second target temperature (Tt2).

A corresponding method is also described.

## Description

### TECHNICAL FIELD OF THE INVENTION

The invention relates to a system for the thermal annealing of a substrate.

More precisely the invention relates to a system for spatially controlling an amount of energy delivered to a processed surface of a substrate illuminated by a pulsed light beam and a method for spatially controlling an amount of energy delivered to a processed surface of a substrate.

### BACKGROUND INFORMATION AND PRIOR ART

To manufacture semiconductor devices, a semiconductor substrate is exposed to a pulsed light beam during a process called thermal processing. During thermal processing, the surface of the areas exposed to the pulsed light beam is heated above 1000°C during several seconds.

The high temperature causes the exposed areas to melt and undergo a structural change. Since the extent of the structural changes is dependent on the temperature, it is critical to control the temperature accurately. Furthermore, some areas of the substrate need to reach a higher temperature than other that are more fragile and could be damaged by a high temperature.

At this stage of the manufacturing, the surface of the substrate has already been processed and displays several patterns. As each pattern has its own optical and thermal properties, each pattern will interact differently with the pulsed light beam. For example, the coating of a pattern determines the amount of light absorbed, and the material and structure of the pattern determines its heat diffusion i.e. the rate at which heat is redistributed across the pattern and to the neighboring areas. As a consequence, the surface temperature is dependent on the pattern of the substrate itself.

As patterned semiconductor substrates usually display a variety of patterns, the resulting surface temperature is difficult to control.

To reduce this "pattern effect", devices of the prior art use two light sources. A first continuous light source emits a light beam configured to heat the patterned surface to a first surface temperature below the target temperature. A second pulsed light source emits a pulsed light beam to provide the necessary energy to reach the target surface temperature. The total temperature nonuniformity observed for these two successive heating is lower than if the patterned surface had directly been heated to the target temperature.

However, the use of two light sources increase the thermal budget of the device, which should be kept low in order not limit its application.

### SUMMARY OF THE INVENTION

Therefore one object of the invention is to provide a system for spatially controlling an amount of energy delivered to a processed surface of a processed substrate comprising a first area and a second area, said first area having a first combination of optical properties and thermal properties, and said second area having a second combination of optical properties and thermal properties, said first combination and second combination being different, said system comprising a light source configured to emit a pulsed light beam towards the processed surface, wherein the pulsed light beam delivers a first amount of energy onto said first area of the processed surface so that said first area reaches a first target temperature, and a second amount of energy to said second area of the processed surface so that said second area reaches a second target temperature.

Due to their different optical properties and thermal properties, the various areas of the processed surface, for example the various areas of a die, have different melt temperatures, and might not need the same amount of energy to reach it. Delivering too much energy to an area causes it to reach a temperature above its melt temperature and damages it. A system that permits to deliver different amounts of energy to different areas of a die helps improving the manufacturing of such die by reducing the damages caused by inappropriate amounts of energy.

Another advantageous and non-limiting feature of the system according to the invention includes:
- the amount of energy is delivered uniformly and simultaneously over each of said area, within +/-1%,
- each area has a surface area at least equal to 1 µm²,
- the system comprises a mask situated between the light source and the processed surface of the processed substrate, said mask comprises: a first zone having a first transmission coefficient determined so that the first amount of energy is delivered to the first area, and a second zone having a second transmission coefficient determined so that the second amount of energy is delivered to the second area.

Using a mask having a plurality of zones having their own transmission coefficient allows controlling the amount of energy delivered to each areas of the die. The mask is easy to insert into an existing system for thermal annealing, as it does not require a lot of volume. In general, systems for thermal annealing already comprise a mask of uniform transmission coefficient to shape the circular light beam into a rectangular light beam. The mask of the invention can replace the mask of uniform transmission, that way there is no need to add extra elements to arrange it in the system for thermal annealing.

Other advantageous and non-limiting features of the system according to the invention include:
- one of the transmission coefficient is zero so as to modify a shape of pulsed light beam,
- the first and second zones have a shape, a dimension and a position that are fixed with respect to the processed substrate,
- the first transmission coefficient and the second transmission coefficient are determined so the first target temperature and the second target temperature are equal,
- wherein the first zone has a first coating configured to determine the first transmission coefficient, and the second zone has a second coating configured to determine the second transmission coefficient,
- the first zone has a first thickness configured to determine the first transmission coefficient and the second zone has a second thickness configured to determine the second transmission coefficient,
- wherein the first zone has a first aperture pattern configured to determine the first transmission coefficient and the second zone has a second aperture pattern configured to determine the second transmission coefficient,
- the mask comprises a digital micromirror device and wherein the system further comprises a controller configured to rotate each of the micro mirrors of the micromirror device so that the first zone achieves the first transmission coefficient and the second zone achieves the second transmission coefficient,
- at least one of the first and second zones has a shape, a dimension or a position that is modifiable with respect to the processed substrate,
- the mask comprises plates that are movable with respect to each other so as to modify the position or shape or dimension of at least one of the first and second zones.

The invention also relates to a method for spatially controlling an amount of energy delivered to a processed surface of a processed substrate, said processed surface comprising a first area and a second area, said first area having a first combination of optical properties and thermal properties, and said second area having a second combination of optical properties and thermal properties, said first combination and second combination being different comprising steps of:
g) emitting, with a light source, a pulsed light beam towards the processed surface,
h) delivering a first amount of energy onto said first area of the processed surface so that said first area reaches a first target temperature,
i) delivering a second amount of energy to said second area of the processed surface so that said second area reaches a second target temperature.

Other advantageous and non-limiting features of the method according to the invention include:
- the first amount of energy is delivered uniformly and simultaneously over the first area, and wherein the second amount of energy is delivered uniformly and simultaneously over the second area within +/- 1%,
- the method comprises steps of f) placing a mask between the light source and the processed surface of the processed substrate, said mask comprising a first zone having a shape homothetic with the shape of the first area of the processed surface, and a second zone having a shape homothetic with the shape of the second area of the processed surface, d) determining a first transmission coefficient of the first zone based on the first amount of energy and a second transmission coefficient of the second zone based on the second amount of energy,
- the first area of the processed of the processed substrate and the second area of the processed surface of the processed substrate are illuminated simultaneously by the pulsed light beam,
- the method comprises steps of: I) placing a mask between the light source and the processed surface of the processed substrate, said mask comprising a first zone having a first transmission coefficient determined so that the first amount of energy is delivered to the first area, and a second zone having a second transmission coefficient determined so that the second amount of energy is delivered to the second area , m) modifying the shape or a dimension or a position of the first zone so that the first zone has a shape that is successively homothetic with the shape of the first area of the processed surface of the processed substrate and with the shape of the second area of the processed surface, so that the first amount of energy is delivered onto said first area and the second amount of energy is delivered to said second area,
- the method comprises steps of a) illuminating a test surface of a test substrate with a light beam, wherein the test surface comprises a test first area having the same combination of optical properties and thermal properties as the first combination of optical properties and thermal properties of the first area of the processed surface of the processed substrate, and a second test area having the same combination of optical properties and thermal properties as the second combination of optical properties and thermal properties of the second area of the processed surface of the processed substrate, b) detecting with a radiation detector, a first electromagnetic radiation and a second electromagnetic radiation respectively emitted by the first area of the test surface and the second area of the test surface, in response to the illumination,
- determining the first amount of energy based on said first electromagnetic radiation, and the second amount of energy based on said second electromagnetic radiation,
- the method comprises a step of generating a map of a spatial distribution of a physical property or physical quantity emitted in response to the illumination of the test surface based on the first electromagnetic radiation and on the second electromagnetic radiation detected on the test surface, wherein the map is used to calculate said amounts of energy delivered onto said processed surface or the shape, dimension and position of said first and second areas of said processed surface.

### DETAILED DESCRIPTION OF EXAMPLE(S)

The system and method according to the invention will be described next, in reference with the appended drawings.

On the appended drawings:
- Figure 1 is a schematic view of an example substrate;
- Figure 2 is a schematic view of an example die supported by the substrate of Figure 1;
- Figure 3 is a schematic view of an example embodiment of the system for controlling the spatial distribution of energy delivered to the die of figure 2;
- Figure 4 is a schematic view of a first embodiment of a mask of the system of figure 3;
- Figure 5 is a schematic view of a second embodiment of the mask of the system in an open configuration,
- Figure 6 is a schematic view of a plate mounted on a pair of sliders of the mask of figure 5,
- Figure 7, is schematic view of the mask of figure 6 in a closed configuration
- Figure 8 is a schematic view of the mask of figure 5 in another open configuration,
- Figure 9 is a schematic representation of the steps of a first embodiment the method according to the invention,
- Figure 10 is a schematic view of a sensor to detect the electromagnetic radiations emitted by a test die when illuminated by a pulsed light beam,
- Figure 11 is a map of the spatial distribution of a physical property or physical quantity emitted in response to the illumination of the test die and based on the electromagnetic radiations detected by the sensor of figure 10,
- Figure 12 is a map of the spatial distribution of temperature of the die of figure 2 when processed by the system according to the invention,
- Figure 13 is a schematic representation of the steps of a second embodiment the method according to the invention.

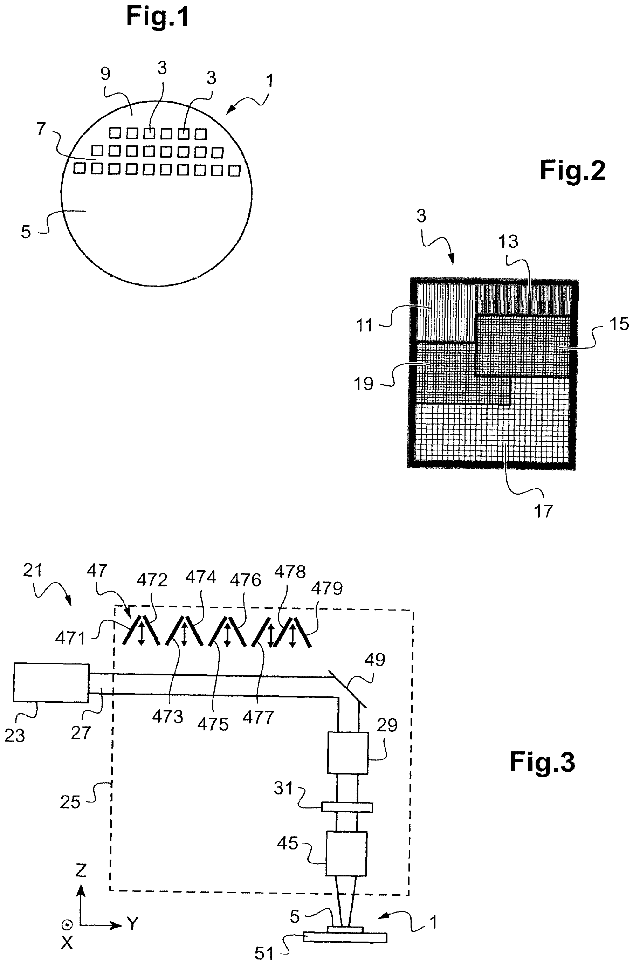

Referring to figure 1, a processed substrate 1 is typically a silicon wafer or a compound wafer, such as commonly used in the semiconductor devices industries. Processed substrate 1 supports an array of dies 3 on its processed surface 5. Dies 3 are separated by scribe lines 7. Processed substrate 1 also comprises a peripheral area 9 situated on its peripheral edge. The peripheral area 9 is too small to support a die.

Referring to Figure 2, each die 3 comprises at least a first area 11 and a second area 13. First area 11 has a first combination of optical properties and thermal properties. Second area 13 has a second combination of optical properties and thermal properties. The first combination and the second combination are different.

Optical properties include pattern density and optical coating. Pattern density (also known as "pattern load") is the repetition rate of the patterns supported by the surface of areas 11, 13 of die 3.

The patterns are formed for example by the arrangement of electronic devices such as transistors, resistor and their metallic interconnects.

For a denser pattern, the surface of the area is more reflective. Hence, the energy delivered by a light beam is lower and the temperature reached by the surface of the area is lower.

On the contrary, for a sparser pattern, the surface of the area is less reflective. Hence, more energy can be delivered by the light beam, and the temperature reached by the surface of the area is higher.

Visible on Figure 2, second area 13 has a denser pattern than first area 11.

First area 11 may correspond to a first functional circuit block of die 3. Second area 13 may correspond to a second functional circuit block of die 3.

Likewise, the surface of an area 11, 13 coated with an optical coating of high reflectivity, reaches a lower temperature than an area 11, 13 coated with an optical coating of low reflectivity.

Thermal properties include the heat diffusion rate of the area 11, 13 considered. Heat diffusion rate is the rate at which heat is redistributed within die 3. Heat diffusion rate depends for example on the materials each area 11, 13 is made of. Hence, first area 11 and second area 13 may have a different heat diffusion rate.

In general, a high heat diffusion rate results in a low surface temperature. A low heat diffusion rate results in a high surface temperature.

Each area 11, 13 has a surface area at least equal to 1 µm by 1 µm and maximum up to 26 mm by 33 mm.

The example die 3 illustrated by Figure 2 comprises a third area 15, a fourth area 17, a fifth area 19.

Third area 15 has a third combination of optical properties and thermal properties. Fourth area 17 has a fourth combination of optical properties and thermal properties. Fifth area 19 has a fifth combination of optical properties and thermal properties. All the combinations may be different. Alternatively, some of the combinations may be similar.

All dies 3 supported by processed surface of processed substrate 1 are similar.

Figure 3 represents a system 21 for spatially controlling an amount of energy delivered to processed surface 5 of processed substrate 1.

System 21 comprises a light source 23 and a beam process module 25.

Light source 23 emits a pulsed light beam 27. Light source 23 is for example a Ultra-Violet (UV) source. Light source 23 is an excimer laser light source. A preferred wavelength of emission is for example 308 nm.

Light source 23 is able to operate in pulsed mode. For example, it can produce nanosecond pulse of 1 to 500 nanosecond FWHM at a rate of 1 to 1MHz.

Pulsed light beam 27 delivers a first amount of energy E1 onto first area 11 of processed surface 5 so that first area 11 reaches a first target temperature Tt1. Pulsed light beam 27 delivers a second amount of energy E2 to said second area 13 of processed surface 5 so that said second area 13 reaches a second target temperature Tt2.

Beam process module 25 is arranged between light source 23 and substrate 1.

Beam process module 25 comprises a beam homogenizer 29 to ensure spatial uniformity of pulsed light beam 27. Beam homogenizer 29 comprises, for example, an array of microlenses or a plurality thereof.

Beam process module 25 comprises a mask 31. Mask 31 is situated between light source 23 and processed surface 5. Mask 31 is situated between beam homogenizer 29 and processed surface 5.

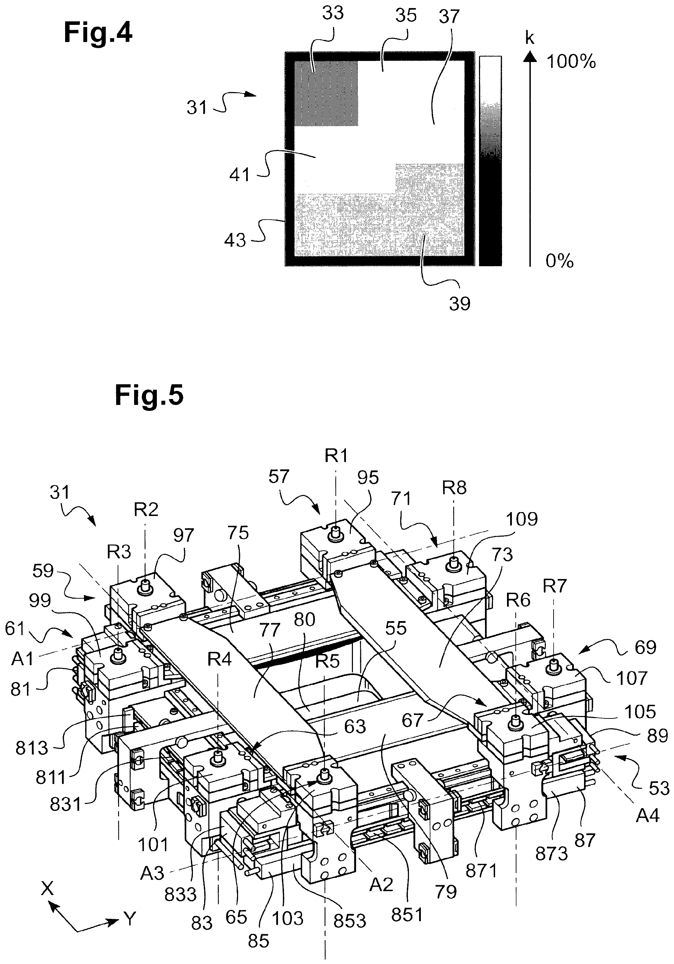

Figure 4 illustrates a first embodiment of mask 31.

Mask 31 comprises a first zone 33 having a first transmission coefficient k1 determined so that first amount of energy E1 is delivered to first area 11, and a second zone 35 having a second transmission coefficient k2 determined so that second amount of energy E2 is delivered to second area 13. First transmission coefficient k1 is comprised between 0% and 100%. Second transmission coefficient k2 is comprised between 0% and 100%.

First amount of energy E1 is determined so that the surface of first area 11 reaches first target temperature Tt1. First target temperature Tt1 is predetermined by a user.

Second amount of energy E2 is determined so that the surface of second area 13 reaches second target temperature Tt2. Second target temperature Tt2 is predetermined by the user.

In an example first target temperature Tt1 is different from second target temperature Tt2. For example, first target temperature Tt1 is the melt temperature of first area 11 and second target temperature Tt2 is the melt temperature of second area 13.

In another example, first target temperature Tt1 is equal to target temperature Tt2. In this case, first transmission coefficient k1 and second transmission coefficient k2 are determined so that die 3 is heated to a uniform temperature.

A method for determining first transmission coefficient k1 and second transmission coefficient k2 is described hereinafter.

In the first embodiment of the mask 31, first zone 33 has a shape homothetic with that of first area 11. Second zone 35 has a shape homothetic with that of second area 13.

In the illustrated example, mask 31comprises a third zone 37, a fourth zone 39, a fifth zone 41 and a sixth zone 43.

Third, fourth and fifth zones 37, 39, 41 have a shape homothetic with that of third, fourth and fifth areas 15, 17, 19 respectfully. Third, fourth and fifth zones 37, 39, 41 respectfully have a third, fourth and fifth transmission coefficient k3, k4, k5 determined so that a third, fourth and fifth amount of energy E3, E4, E5 is respectfully delivered to third, fourth and fifth areas 15, 17, 19. The third, fourth and fifth amounts of energy E3, E4, E5 are determined so that the surface of third, fourth and fifth areas 15, 17, 19 respectfully reaches a third, fourth and fifth target temperature Tt3, Tt4, Tt5. Third, fourth and fifth target temperatures Tt3, Tt4, Tt5 are predetermined by a user. Third, fourth and fifth target temperatures Tt3, Tt4, Tt5 are for example equal to the respective melt temperature of third, fourth and fifth areas 15, 17, 19.

The target temperatures Tt1 - Tt5 may all be different. Alternatively, some of the target temperatures Tt1 - Tt5 may be equal.

All the transmission coefficients k1 - k5 of all the zones 33 - 41 may be different. Alternatively, some of the transmission coefficients k1 - k5 may be equal. On the illustrated example, third transmission coefficient k3 and fifth transmission coefficient k5 are equal.

Sixth zone 43 is the rim of mask 31. The sixth transmission coefficient k6 of sixth zone 43 is for example 0%. Sixth zone 43 modifies the shape of pulsed light beam 27.

In the first embodiment of mask 31, the shape, dimension and position of first and second zones 33, 35 are fixed with respect to processed substrate 1. In other words, the shape, dimension and position of first and second zones 33, 35 do not vary during the annealing of die 3.

In the illustrated example of mask 31, the shape, dimension and position of third, fourth, fifth and sixth zones 37 - 43 are fixed with respect to processed substrate 1. In other words, the shape, dimension and position of third, fourth, fifth and sixth zones 37 - 43 do not vary over time.

As shown on figure 3, beam process module 25 comprises a lens assembly 45 to demagnify the image of mask 31. The optical magnification of lens assembly 45 is such that the dimension size, or size, of the image of mask 31 projected on die 3 is equal to the dimension, of die 3.

More precisely, the dimensions of the images of first, second, third, fourth and fifth zones 37 - 41 31 projected on die 3 is equal to the dimensions of first, second, third, fourth and fifth areas 11 -19 respectively.

In operation, pulsed light beam 27 illuminates mask 31. Pulsed light beam 27 illuminates uniformly and simultaneously each of first, second, third, fourth and fifth zones 33 - 43. The first amount is delivered uniformly and simultaneously over first area 11 within * %.

Pulsed light beam 27 is partially transmitted by mask 31 according to the transmission coefficient k1 - k6 of each zone 37 - 43 of mask 31.

In an example of the first embodiment of mask 31, mask 31 is made of a transparent substrate coated by different thin films. Mask 31 is covered with a plurality of optical coatings to achieve specific transmission coefficient. An optical coating can be a single thin film of a given material or a stack of multiple thin films.

First zone 33 is covered with a first optical coating having a first reflectance. The first optical coating determines first transmission coefficient k1.

Second zone 35 is covered with a second optical coating having a second reflectance. The second optical coating determines second transmission coefficient k2.

An optical coating of higher reflectance has a lower the transmission coefficient than another optical coating of lower reflectance.

In another example of the first embodiment of mask 31, mask 31 is made of an absorbent material. Mask 31 has a thickness that extends in the direction of the propagation of the light (here along the Z-axis visible on Figure 3).

First zone 33 has a first thickness. The first thickness is determined so that first zone 33 achieves first transmission coefficient k1.

Second zone 35 has a second thickness. The second thickness is determined so that second zone 35 achieves second transmission coefficient k2.

For a large thickness, the transmission coefficient is lower than for a smaller thickness as more light is absorbed by mask 31.

In another example of the first embodiment of mask 31, mask 31 has a cross-hatched aperture pattern to determine its transmission coefficients. Here, the cross-hatched aperture pattern comprises a succession of slits and gaps. The slits are configured to transmit light, the gaps are configured to absorb or reflect light. The transmission coefficient of the cross-hatched aperture pattern depends on the width of the slits. The transmission coefficient of the cross-hatched aperture pattern also depends on the width of the gap.

First zone 33 has a first cross-hatched aperture pattern that determines first transmission coefficient k1.

Second zone 35 has a second cross-hatched aperture pattern that determines second transmission coefficient k2.

In another example of the first embodiment of mask 31, mask 31 comprises a digital micromirror device, for example Texas Instrument Digital Micromirror Device. The digital micromirror device comprises an array of micromirror. Each micromirror can be orientated individually thanks to a controller (not represented) of beam process module 25. The controller may be equipped with a user interface, so that a user may select first transmission coefficient k1 and second transmission coefficient k2.

By orientating the micromirrors, the amount of light reflected and the amount of light transmitted can be determined.

The micromirrors over first zone 33 are orientated in a first direction. The first direction of orientation determines the first transmission.

The micromirrors over second zone 35 are orientated in a second direction. The second direction of orientation determines the second transmission.

Referring back to Figure 3, beam process module 25 may comprise an attenuation module 47. Attenuation module 47 comprises an attenuation plate or a combination thereof 471, 472, 473, 474, 475, 476, 477, 478, 479.

A controller (not represented) modifies a transmission coefficient kmod of attenuation module 47 by placing or removing attenuation plates 471 - 479 in the path of pulsed light beam 27.

System 21 may also include a folding mirror 49 or a combination thereof to make system 21 more compact while providing the desired orientation to pulsed light beam 27.

In the illustrated example, substrate 1 is situated on a translation stage 51. Translation stage 51 is connected to a step by step motor (not represented). The step by step motor moves the translation stage 51 in translation in the (XY) plane so that each die 3 of the array is illuminated by pulsed light beam 27 in turn.

Figure 5 illustrates another embodiment of mask 31. On this figure 5, mask 31 is in an open configuration.

Masks 31 comprises a frame 53 which has an opening 55 formed therein. A plurality of sliders 57, 59, 61, 63, 65, 67, 69, 71 are slidably mounted on frame 53, and a plurality of plates 73, 75, 77, 79 are mounted on the sliders.

In the illustrated example, frame 53 comprises four sides of equal length and four right angles. Opening 55 has a square shape. Each side of frame 53 extends along a respective translation axis A1, A2, A3, A4.

Other types of frame are possible, for example, frame 53 may have sides of different length to define a rectangular opening 55. Alternatively frame 53 may not have right angle. Alternatively frame 53 may have more than or less than four sides.

In the illustrated example, two sliders 57 - 71 are mounted on each of the sides of frame 53.

Each slider 57 - 71 is equipped with a motor, here a linear motor 81, 83, 85, 87, 89 (only five of which are visible on Figure 5). Motors 81 - 89 have a magnetic track 811, 831, 851, 871 (only four of which are visible) which is mounted on a respective side of frame 53, so as to be aligned with a translation axis A1, A2, A3, A4. Each magnetic track 811 - 871 supports a mover 813, 833, 853, 873. One slider 57 - 71 is mounted on each mover 813 - 873.

A mount 95, 97, 99, 101, 103, 105, 107, 109 is pivotably mounted on each slider 57 - 71. Each mount 95 - 109 turns about a respective pivot axis R1, R2, R3, R4, R5, R6, R7, R8. Pivot axes R1 - R8 are parallel to each other. Pivot axes R1 - R8 are perpendicular to translation axes A1 - A4.

Each of the plates 73 - 79 have two extremities, each of the extremities of the plates 73 - 79 is fixed to a mount 95 - 109 of a slider 57 - 71 situated on an opposite side of the frame 53. Thus each plate 73 - 79 extends across opening 55.

Plates 73 - 79 are rigid. Plates 73 - 79 are made, for example of silicon carbide (SiC) or aluminum oxide (AlO3).

The transmission coefficients of plates 73 - 79 are comprised between 0% and 100 %. In one example, the transmission coefficients of plate 73 - 79 are equal. In another example, the transmission coefficients of plate 73 - 79 are different.

The area between the plates 73 - 79 corresponds to a zone of mask 31, for example first zone 33. The area between the plates 73 - 79 is a hole 80.

The area defined by the plates 73 - 79 corresponds to another zone of mask 31, for example second zone 35.

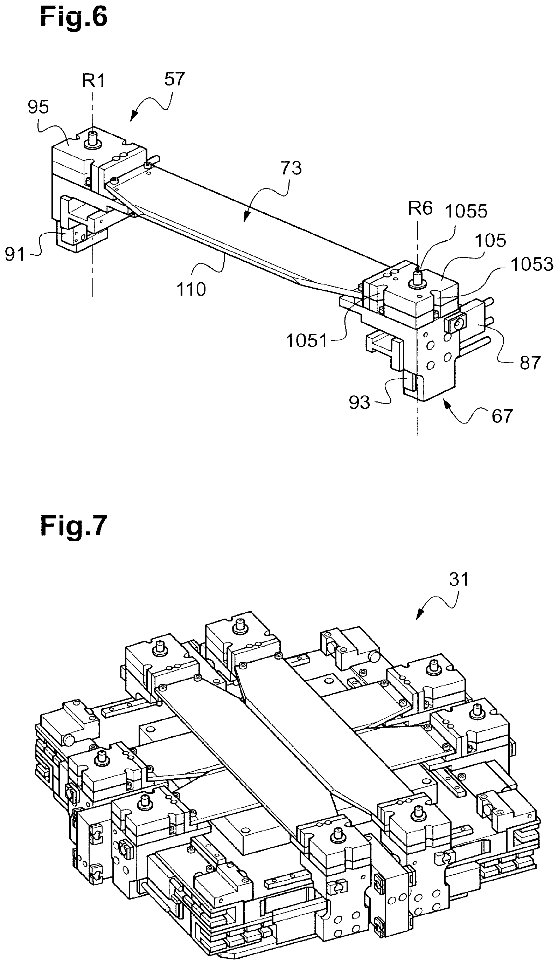

Figure 6 illustrates a plate 73 mounted on a pair of sliders 57, 67.

Each slider 57, 67 is equipped with an encoder 91, 93 to know its position along the magnetic track.

As shown by Figure 6, an inner edge 110 of plate 73 is beveled. The beveled inner edge 110 improves achieving a sharp image of mask 31 on substrate 1.

Mounts 95 - 109 are resiliently deformable under torsion. To this effect, each mount 95 - 109 presents at least one notch 1051, 1053, 1055. In the example illustrated on Figure 6, each mount 95, 105 presents three notches 1051, 1053, 1055.

A controller (not represented) is configured to command motors 81 - 89.

In operation, the controller commands the displacement of the movers 813 - 893 along their respective magnetic track 811 - 871. Thus the sliders 57 - 71 move in translation along their respective translation axis A1 - A4.

When the sliders of a pair of sliders that supports a plate are moved by the same distance, then the plate is displaced along a single axis in the (XY) plane.

In the example illustrated by figure 7, all the sliders 57 - 71 are moved the same distance. Consequently all the plates 73 - 79 are moved linearly, here towards the center of opening 55. In this example, the plates 73 - 79 are moved so as to close opening 55. Mask 31 is in a closed configuration.

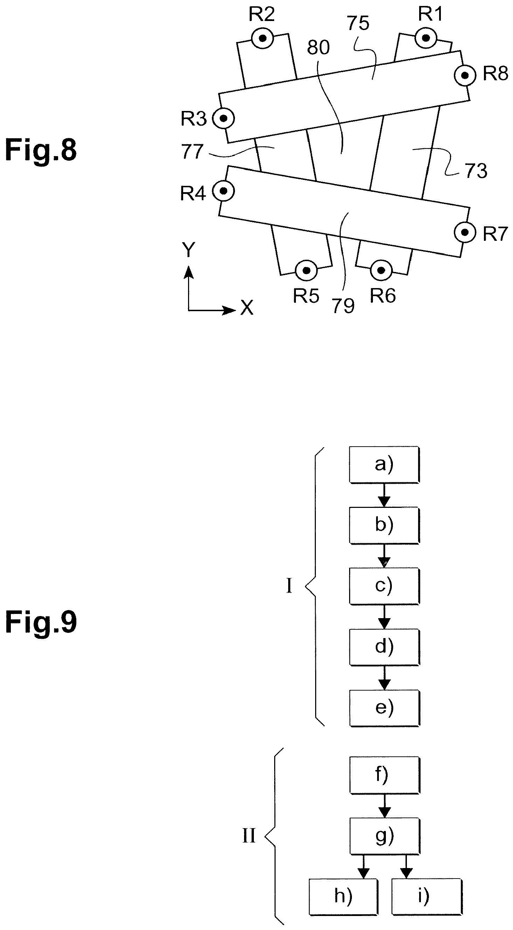

In the example illustrated by Figure 8, the sliders 57 - 71 of a pair of sliders that supports a plate 73 - 79 are moved by a different distance, the plate 73 - 79 rotates in the (XY) plane. This is due to the elastic deformation of mounts 95 - 109 that allows the mounts 95 - 109 to rotate around the rotation axes R1 - R8.

In this embodiment of mask 31, at least one of the first and second zones 33, 35 has a shape, a dimension or a position that is modifiable with respect to the processed substrate.

The controller is adapted to move plates 73 - 79 with respect to each other so as to modify the position, shape or dimension of at least one of the first zone 33 and second zone 35.

The controller is adapted to move plates 73 - 79 so that the shape of the hole 80 is homothetic with the shape of one of the areas 11, 13, 15, 17, 19 of die 3.

In other words, the controller is adapted to move plates 73 - 79 so that the position of first zone 33 is aligned with one of the areas 11 - 19. In this context "aligned" means that the image of first zone 33 is projected onto one of the area 11 - 19.

A method for spatially controlling an amount of energy delivered to processed surface 5 of processed substrate 1 is now described.

A first embodiment of the method is implemented with the first embodiment of mask 31. The steps of the first embodiment of the method are schematically represented on figure on Figure 9.

In a first phase I of the first embodiment of the method, at least one parameter of mask 31 is determined. The parameter of mask 31 is selected from a group comprising: the transmission coefficients of the zones 33 - 41, the shape of the zones 33 - 41, the dimension of the zones 33 - 41.

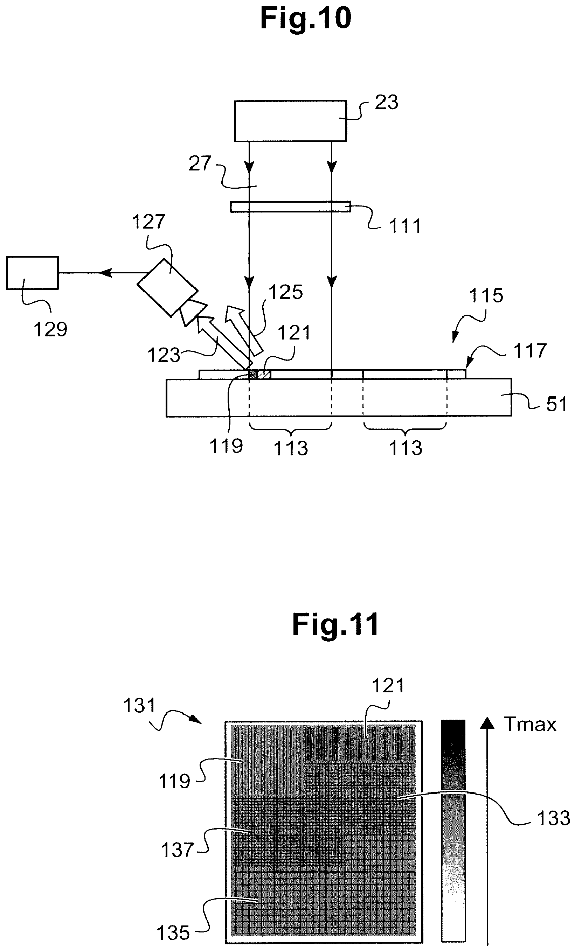

Referring to figure 10, in a step a), light source 23 emits pulsed light beam 27. Pulsed light beam 27 is received and transmitted by a mask of uniform transmission 111. Mask of uniform transmission 111 shapes pulsed light beam 27 to give it a rectangular shape corresponding to the shape of test die 113.

A test substrate 115 is placed on translation stage 51. Test substrate 115 supports an array of test dies 113 on its test surface 117. Test substrate 115 is similar to substrate 1. Alternatively, test substrate 115 may support a lesser number of test dies 113. The test dies 113 supported by test substrate 115 are similar to the dies 3 supported by processed substrate 1.

In other words, test surface 117 of test substrate 115 comprises a first test area 119 having the same combination of optical properties and thermal properties as the first combination of optical properties and thermal properties of first area 11 of the processed surface 5 of the processed substrate 1, and a second test area 121 having the same combination of optical properties and thermal properties as the second combination of optical properties and thermal properties of second area 13 of the processed surface 5 of the processed substrate 1.

In this example, test die 113 also comprises a third, fourth and fifth test areas 133, 135, 137 (represented on Figure 11) having the same combination of optical properties and thermal properties as third, fourth and fifth areas 15, 17, 19 respectively. An arrow Tmax indicates the increasing temperatures.

Mask of uniform transmission 111 has a uniform transmission coefficient over its whole surface. As a consequence, test surface 115 is illuminated uniformly, whole test die 113 receives the same amount of energy from pulsed light beam 27.

The energy received by test surface 115 is then converted into heat and the surface temperature of test surface rises. As explained before, the temperature reached depends on the combination of optical properties and thermal properties of the areas of test surface 115.

Here one test die 113 is illuminated by pulsed light beam 27.

The first combination of optical properties and thermal properties leads first test area 119 to be heated to a first temperature T1 when illuminated by pulsed light beam 27.

The second combination of optical properties and thermal properties leads second area 121 to be heated to a second temperature T2 when illuminated by pulsed light beam 27.

In response to the illumination, each test area 119, 121 emits a respective electromagnetic radiation 123, 125 that is proportional to its temperature T1, T2. First test area 119 emits a first electromagnetic radiation 123. Second test area 121 emits a second electromagnetic radiation 125.

The electromagnetic radiations emitted by third, fourth and fifth test areas are not represented.

In a step b), a radiation detector 127 detects first electromagnetic radiation 123 and second electromagnetic radiation 125.

Radiation sensor 127 is adapted to detect a physical quantity of test substrate 115. For example, radiation sensor 127 is a thermal sensor adapted to detect thermal electromagnetic radiation 123, 125.

Alternatively, radiation sensor 127 is adapted to detect a physical property of test substrate 115. For example, radiation sensor 127 is an optical sensor adapted to detect electromagnetic radiation 123, 125 in a shape light reflected on the surface of die 3.

Radiation detector 127 captures a spatial distribution of the electromagnetic radiation 123, 125 of whole surface of test die 113 and transmits it to a calculating unit 129, for example a computer.

In a step c), calculating unit 129 determines the amounts of energy E1 - E5 based on the amount of electromagnetic radiations 123, 125 emitted by each test areas 119, 121, 133 137.

More precisely, calculating unit 129 determines the first amount of energy E1 necessary so that first area 11 reaches first target temperature Tt1. Calculating unit 129 determines the second amount of energy E2 so that second area 13 reaches second target temperature Tt2.

To determine the amounts of energy E1 - E5, calculating unit 129 is programmed to calculate a temperature associated with an electromagnetic radiation.

The coordinates of the test areas 119, 121 of test die 113 are known and can be input and memorized in calculating unit 129. Calculating unit 129 generates a spatial map of test die 3 based on the coordinates of the test areas 119, 121.

Calculating unit 129 generates a map of the spatial distribution of temperature 131 of test die 113 based on spatial map of test die 3 and on the detected electromagnetic radiations 123, 125. Figure 11 illustrates an example of the map of the spatial distribution of temperature 131 of test die 113. Here, the first temperature T1 of first test area 119 is the lowest. The second temperature T2 of second test area 121 is the highest.

The temperature spatial distribution map 131 accounts not only for optical properties of each area (how much light is reflected) but also for their thermal properties (areas with high heat diffusion rate transmit heat to adjacent area of lower heat diffusion rate).

Alternatively, the coordinates of the areas of test die 113 are not known. Calculating unit 129 determines the coordinates of the areas of test die 113 based on the temperature distribution of test die 113.

Calculating unit 129 may generate a map of the spatial distribution of the relative temperature within die 3. For example, first temperature T1 is considered the "reference" temperature, calculating unit 129 then determines how much higher or lower the temperatures of the other areas are compared to the reference temperature. For example the second temperature T2 may be 110% of reference temperature, temperature T3 may be 90% of reference temperature.

An energy detector (not represented), for example a photodiode, is arranged to detect the power of pulsed light beam 27.

Calculating unit 129 determines the amounts of energy E1 - E5 based on the power detected, the temperature reached by test areas 119, 121, 133, 135, 137 when illuminated by pulsed light beam 27 and the respective target temperature Tt1 - Tt5 of the area 11 - 19.

In a step d), calculating unit 129 determines the transmission coefficients k1 - k5 of the different zones 33-41 of mask 31 based on the amounts of energy E1 - E5.

The transmission coefficients k1 - k5 are a measure of how much the power emitted by pulsed light beam 27 is attenuated before reaching die 3.

The transmission coefficients k1 - k5 of the zones 33 - 41 of mask 31 are then memorized in a file.

In a step e), mask 31 is fabricated based on the memorized file.

The transmission coefficients k1 - k5 of the zones 33 - 41 are achieved as described previously (different optical coatings, different thicknesses etc.).

In a second phase of the method, processed surface 5 is annealed.

In a step f), mask 31 is placed between light source 23 and processed surface 5 of processed substrate 1. Processed substrate 1 is situated on translation stage 51. The processed surface 5 of processed substrate is directed toward the system 21 for spatially controlling the amount of energy delivered.

Mask 31 comprises first zone 33 having a shape homothetic with the shape of first area 11 of processed surface 5, and a second zone 35 having a shape homothetic with the shape of second area 13 of the processed surface 5.

Mask 31 is oriented so that first zone 33 is aligned with first area 13, second zone 35 is aligned with second area 13, third zone 37 is aligned with third area 15, fourth zone 39 is aligned with fourth area 17 and fifth zone 41 is aligned with fifth area 19.

In this context "aligned" means that the image of each zone 33 - 41 is projected onto its associated area 11 - 19.

In a step g), light source 23 emits pulsed light beam 27 towards processed surface 5. Mask 31 receives pulsed light beam 27 and transmits pulsed light beam 27 at least partially.

In a step h), first amount of energy E1 is delivered onto first area 11 of die 3. First amount of energy E1 is delivered uniformly and simultaneously over first area 11 within +/- 1%. First area 11 reaches first target temperature Tt1.

In a step i), second amount of energy E2 is delivered onto second area 13 of die 3. Second amount of energy E2 is delivered uniformly and simultaneously over the second area within +/- 1%.

Likewise, third, fourth and fifth amount of energy E3 - E5 are delivered uniformly and simultaneously onto third, fourth and fifth area 15 - 19 respectively area within +/- 1%.

In the first embodiment of the method, first area 13 of processed surface 5 of processed substrate 1 and the second area 13 of processed surface 5 of processed substrate 1 are illuminated simultaneously by pulsed light beam 27.

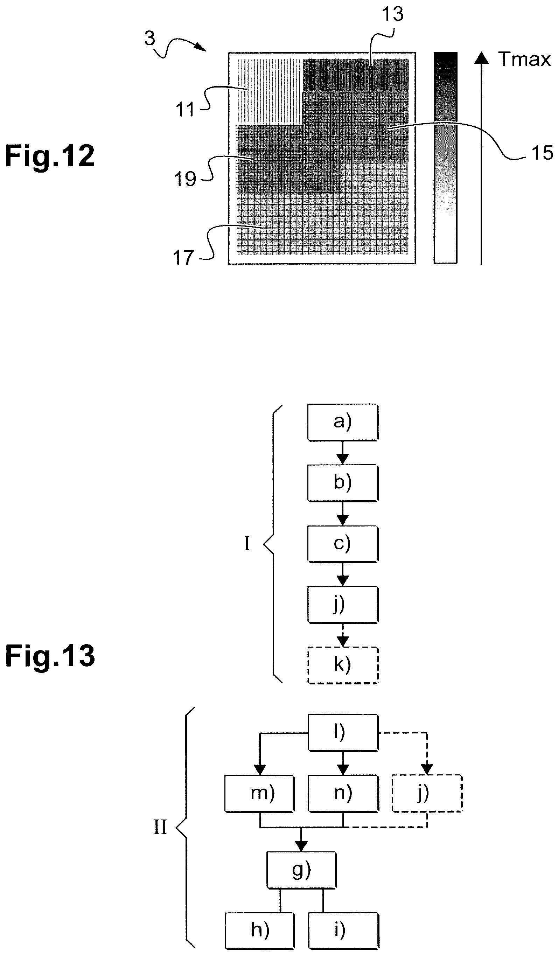

Figure 12 illustrates the temperature distribution of die 3 processed according to the method of the invention. On this illustrated example, all the target temperatures Tt1 - Tt6 are equal.

A second embodiment of the method is implemented with the second embodiment of mask 31. In this second embodiment, the shape, dimension or position of zones 33 - 41 of mask 31 are variable with respect to processed substrate 1.

In a first phase of the second embodiment of the method, steps a), b) and c) are implemented as described in the first phase of the first embodiment of the method.

During a step j), calculating unit 129 elaborates a command to displace plates 73 - 79 so that hole 80 has a shape successively homothetic with that of the areas 11 - 19 of processed surface 5, and that hole 80 is successively aligned with areas 11 - 19.

In an example, in a step k), calculating unit 129 determines values kmod 1 - kmod5 of transmission coefficient kmod of attenuation module 47, and elaborates a command so that the attenuation module 47 attenuates the emitted pulsed light beam 27 to deliver the amounts of energy E1 - E5 to their respective area 11 - 19. For example, to deliver first amount of energy E1 onto first area 11, pulsed light beam is attenuated by a first transmission coefficient value kmod1 of attenuation module 47.

The values kmod 1 - kmod5 of the transmission coefficient kmod are determined based on the power of pulsed light beam 27, the temperatures T1 - T5 reached by test areas 119, 121 and on target temperatures Tt1-Tt5 of areas 11 - 19 as described in step d).

During a step I) of a second phase of the second embodiment of the method, the second embodiment of mask 31 is placed between light source 23 and the processed surface 5 of the processed substrate 1.

Processed substrate 1 is situated on translation stage 51. The processed surface 5 of processed substrate is directed toward the system 21 for spatially controlling the amount of energy.

During a step m), the shape or a dimension or a position of first zone 33 is modified so that first zone 33 has a shape that is successively homothetic with the shape of each of the areas 11 - 19 of the processed surface 5 of the processed substrate 1 and is successively aligned with the areas 11 - 19 so that the respective amount of energy E1- E5 is delivered onto each of the areas 11 - 19.

For example, the shape or dimension or position of first zone 33 is modified so that first zone 33 has a shape homothetic with the shape of first area 11, and with the shape of second area 13 of the processed surface 5, so that first amount of energy E1 is delivered onto said first area and the second amount of energy E2 is delivered to said second area 13.

More precisely, at a first time t1, the controller sends the elaborated command to linear motors 81 - 89 to move plates 73 - 79. For example, the plates 73 - 79 move so that hole 80, corresponding to first zone 33 of mask 31, has a shape homothetic with that of first area 11 and is aligned with first area 11.

In a step n), the transmission coefficient kmod of attenuation module 47 is modified so attenuation module 47 transmits pulsed light beam 27 with a first transmission coefficient value kmod1.

Steps m) and n) may be implemented simultaneously or successively.

In a step g), light source 23 emits pulsed light beam 27.

In a step h), first amount of energy E1 is delivered onto first area 11 of processed surface 5 so that first area 11 reaches first target temperature Tt1.

In this example, the transmission coefficient of plates 73 - 79, that correspond to second zone 35, is zero. As a consequence, the amounts of energy E2- E5 delivered to second, third, fourth and fifth areas 13 - 19 is zero, since pulsed light beam 27 does not illuminates these areas 13 - 19.

At a second time t2, in step m) plates 73 - 79 move so that hole 80, has a shape homothetic with that of second area 13 and is aligned with first area 13.

In a step n), the transmission coefficient kmod of attenuation module 47 is modified so attenuation module 47 transmits pulsed light beam 27 with a second transmission coefficient value kmod2.

In step g), light source 23 emits pulsed light beam 27.

In a step i) second amount of energy E2 is delivered onto second area 13 of processed surface 5 so that second area 13 reaches second target energy Tt2.

The amount of energy E1, E3 - E5 delivered to non illuminated areas 11, 15 - 19 is zero.

The steps m), n) and g) are repeated until the amounts of energy E1 - E5 are delivered to their respective areas 11 - 19 and the areas 11 - 19 have reached their respective target temperatures Tt1 - Tt5.

In another example, the first area 11 is illuminated during a first exposure time Δt1.

The variation in exposure time Δt1 -Δt5 may be combined with the variation in transmission coefficient kmod of attenuation module 47. Alternatively, in another example, only the variation in exposure time Δt1 -Δt5 is implemented and the transmission coefficient kmod of the attenuation module is fixed.

## Claims

1. System (21) for spatially controlling an amount of energy delivered to a processed surface (5) of a processed substrate (1) comprising a first area (11) and a second area (13), said first area (11) having a first combination of optical properties and thermal properties, and said second area (13) having a second combination of optical properties and thermal properties, said first combination and second combination being different, said system (21) comprising a light source (23) configured to emit a pulsed light beam (27) towards the processed surface (5), wherein the pulsed light beam (27) delivers a first amount of energy (E1) onto said first area (11) of the processed surface (5) so that said first area (11) reaches a first target temperature (Tt1), and a second amount of energy (E2) to said second area (13) of the processed surface (5) so that said second area (13) reaches a second target temperature (Tt2).

2. System (21) according to claim 1, wherein the amount of energy (E1, E2) is delivered uniformly and simultaneously over each of said area (11, 13), within +/- 1 %.

3. System (21) according to claim 1 or 2, wherein each area (11, 13) has a surface area at least equal to 1 µm².

4. System (21) according to any of claims 1 to 3, comprising a mask (31) situated between the light source (23) and the processed surface (5) of the processed substrate (1), said mask (31) comprising:
- a first zone (33) having a first transmission coefficient (k1) determined so that the first amount of energy (E1) is delivered to the first area (11), and
- a second zone (31) having a second transmission coefficient (k2) determined so that the second amount of energy (E2) is delivered to the second area (13).

5. System (21) according to claim 4, wherein one of the transmission coefficient (k1, k2) is zero so as to modify a shape of pulsed light beam (27).

6. System (21) according to claim 4 or 5, wherein the first and second zones (33, 35) have a shape, a dimension and a position that are fixed with respect to the processed substrate (1).

7. System (21) according to any of claims 4 to 6, wherein the first transmission coefficient (k1) and the second transmission coefficient (k2) are determined so the first target temperature (Tt1) and the second target temperature (Tt2) are equal.

8. System (21) according to any of the claims 4 to 7, wherein the first zone (33) has a first coating configured to determine the first transmission coefficient (k1), and the second zone (35) has a second coating configured to determine the second transmission coefficient (k2).

9. System (21) according to any of the claims 4 to 8, wherein the first zone (33) has a first thickness configured to determine the first transmission coefficient (k1) and the second zone (35) has a second thickness configured to determine the second transmission coefficient (k2).

10. System (21) according to any of the claims 4 to 9, wherein the first zone (33) has a first aperture pattern configured to determine the first transmission coefficient (k1) and the second zone (35) has a second aperture pattern configured to determine the second transmission coefficient (k2).

11. System (21) according to any of claims 4 to 8, wherein the mask (31) comprises a digital micromirror device and wherein the system (21) further comprises a controller configured to rotate each of the micro mirrors of the micromirror device so that the first zone (33) achieves the first transmission coefficient (k1) and the second zone (35) achieves the second transmission coefficient (k2).

12. System (21) according to claim 4 or 5, wherein at least one of the first and second zones (29, 31) has a shape, a dimension or a position that is modifiable with respect to the processed substrate (1).

13. System (21) according to claim 12, wherein the mask (31) comprises plates (73, 75, 77, 79) that are movable with respect to each other so as to modify the position or shape or dimension of at least one of the first and second zones (33, 35).

14. Method for spatially controlling an amount of energy delivered to a processed surface (5) of a processed substrate (1), said processed surface (5) comprising a first area (11) and a second area (13), said first area (11) having a first combination of optical properties and thermal properties, and said second area (13) having a second combination of optical properties and thermal properties, said first combination and second combination being different comprising steps of:
g) emitting, with a light source (23), a pulsed light beam (27) towards the processed surface (5),
h) delivering a first amount of energy (E1) onto said first area (11) of the processed surface (5) so that said first area (11) reaches a first target temperature (Tt1),
i) delivering a second amount of energy (E2) to said second area (13) of the processed surface (5) so that said second area (13) reaches a second target temperature (Tt2).

15. Method according to claim 14, wherein the first amount of energy (E1) is delivered uniformly and simultaneously over the first area (11), and wherein the second amount of energy (E2) is delivered uniformly and simultaneously over the second area (13) within 1%.

16. Method according to any one of claims 14 and 15, comprising steps of:
f) placing a mask (31) between the light source (19) and the processed surface (5) of the processed substrate (1), said mask (31) comprising a first zone (33) having a shape homothetic with the shape of the first area (11) of the processed surface (5), and a second zone (35) having a shape homothetic with the shape of the second area (13) of the processed surface (5),
d) determining a first transmission coefficient (k1) of the first zone (33) based on the first amount of energy (E1) and a second transmission coefficient (k2) of the second zone (31) based on the second amount of energy (E2).

17. Method according to claim 16, wherein the first area (11) of the processed surface (5) of the processed substrate (1) and the second area (13) of the processed surface (5) of the processed substrate (1) are illuminated simultaneously by the pulsed light beam (27).

18. Method according to any of claims 14 and 15, comprising steps of:
I) placing a mask (31) between the light source (23) and the processed surface (5) of the processed substrate (1), said mask (31) comprising a first zone (33) having a first transmission coefficient (k1) determined so that the first amount of energy (E1) is delivered to the first area (11), and a second zone (35) having a second transmission coefficient (k2) determined so that the second amount of energy (E2) is delivered to the second area (13),
m) modifying the shape or a dimension or a position of the first zone (33) so that the first zone (33) has a shape that is successively homothetic with the shape of the first area (11) of the processed surface (5) of the processed substrate (1) and with the shape of the second area (13) of the processed surface (5), so that the first amount of energy (E1) is delivered onto said first area (11) and the second amount of energy (E2) is delivered to said second area (13).

19. Method according to any one of claims 14 to 18, comprising steps of:
a) illuminating a test surface (117) of a test substrate (115) with a light beam (27), wherein the test surface (117) comprises a first test area (119) having the same combination of optical properties and thermal properties as the first combination of optical properties and thermal properties of the first area (11) of the processed surface (5) of the processed substrate (1), and a second test area (121) having the same combination of optical properties and thermal properties as the second combination of optical properties and thermal properties of the second area (13) of the processed surface (5) of the processed substrate (1),
b) detecting with a radiation detector (127), a first electromagnetic radiation (123) and a second electromagnetic radiation (125) respectively emitted by the first test area (119) of the test surface (117) and the second test area (121) of the test surface (117), in response to the illumination,
c) determining the first amount of energy (E1) based on said first electromagnetic radiation (123), and the second amount of energy (E2) based on said second electromagnetic radiation (125).

20. Method according to claim 19, comprising a step of generating a map of a spatial distribution of a physical property or physical quantity emitted in response to the illumination (46) of the test surface (117) based on the first electromagnetic radiation (123) and on the second electromagnetic radiation (125) detected on the test surface (117), wherein the map is used to calculate said amounts of energy delivered onto said processed surface (5) or the shape, dimension and position of said first and second areas (11, 13) of said processed surface (5).
